(19) Europäisches Patentamt / European Patent Office / Office européen des brevets

(11) **EP 4 492 927 A1**

(12) **EUROPEAN PATENT APPLICATION**

(43) Date of publication:
**15.01.2025** Bulletin 2025/03

(21) Application number: **24165021.7**

(22) Date of filing: **21.03.2024**

(51) International Patent Classification (IPC):
**H05K 3/00** (2006.01)   **H05K 1/03** (2006.01)
**H05K 3/38** (2006.01)   **H05K 3/10** (2006.01)

(52) Cooperative Patent Classification (CPC):
**H05K 3/0026;** H05K 1/0373; H05K 3/0035;
H05K 3/0055; H05K 3/10; H05K 3/381;
H05K 2201/0209; H05K 2203/0557

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **12.07.2023   CN 202310855756**

(71) Applicant: **AT & S Austria Technologie & Systemtechnik Aktiengesellschaft**
**8700 Leoben-Hinterberg (AT)**

(72) Inventors:
• **Wang, Nina**
**Chongqing, 401133 (CN)**
• **Baftiri, Artan**
**Chongqing, 401121 (CN)**

(74) Representative: **Dilg, Haeusler, Schindelmann Patentanwaltsgesellschaft mbH**
**Leonrodstraße 58**
**80636 München (DE)**

(54) **COMPONENT CARRIER AND METHOD FOR MANUFACTURING THE SAME AND USING OF A DESMEAR PROCESS**

(57)   There is described a component carrier (100), comprising:

a stack (101) comprising at least one electrically conductive layer structure (104) and at least one electrically insulating layer structure (102),
wherein the at least one electrically insulating layer structure (102) comprises:
i) an insulating material (110), and
ii) fillers (120) embedded in the insulating material (110), wherein at least one of said fillers (120) is exposed at one of the main surfaces of the electrically insulating layer structure (102), and
wherein said at least one exposed filler (120) comprises a high-roughened surface portion (125) and a low-roughened surface portion (126).

Fig. 1

EP 4 492 927 A1

# EP 4 492 927 A1

**Description**

<u>Technical Field</u>

The invention relates to a component carrier having an insulating material with embedded fillers, wherein at least one filler is exposed and comprises a high-roughness surface portion and a low-roughness surface portion. Further, the invention relates to a method of manufacturing the component carrier, in particular using a desmear process. The invention further relates to a specific use of an excimer laser to perform a desmear process and have a more uniform roughness on the surface.

Thus, the invention may relate to the technical field of manufacturing a component carrier such as a printed circuit board or an IC substrate.

<u>Technical Background</u>

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. Also an efficient protection against electromagnetic interference becomes an increasing issue. At the same time, component carriers shall be mechanically robust and electrically and magnetically reliable so as to be operable even under harsh conditions.

For example, there may be applied a so-called desmear process during component carrier manufacture. This process may be used to clean component carrier preform (so-called panels) surfaces and bore holes, in particular by removing resin smears. This process may provide a surface roughness that can be required to improve the adhesion for a further layer, e.g. a copper layer, to the surface to be desmeared.

Conventionally, the desmear process is performed as a wet process, in particular by etching (e.g. using permanganate (ion)) the component carrier preform surface. However, in case that the component carrier layer at the surface to be etched comprises embedded particles, several drawbacks may occur. For example, the etching can affect a resin material (significantly) stronger than the filler material. In the case of silicon dioxide ($SiO_2$) filler particles, these are generally not affected by etching, while the resin, in which they are embedded, is removed by the etching.

When the resin in close proximity to respective filler particles is etched too much, the filler particles might not be bonded with the resin tightly enough, and then filler particles might detach from the resin and drop, e.g. in the chemical process tank, which may contaminate the chemistry/products and may cause the waste of materials and quality issues of the products may arise. Additionally, the desmear process may not be able to form a uniform roughness of the insulating layer surface, therefore it might be difficult for fine line structuring and also cause some quality issues of products.

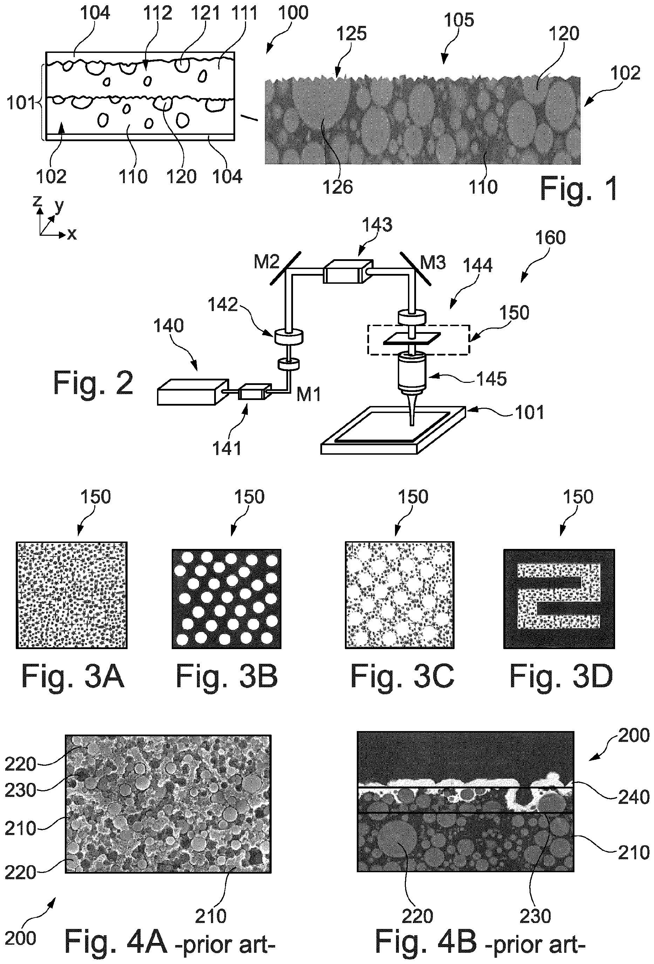

**Figures 4A and 4B** respectively show a conventional circuit board 200 with a resin material 210. The resin material 210 comprises a plurality of filler particles 220 embedded therein.

Figure 4A: in this top view onto the resin material 210 exposed main surface, it can be seen that there are some holes 230 present. Since the desmear etching process removes resin material 210 around the silicon dioxide filler particles 220, but does not affect the filler particles 220 themselves, these can simply drop out of the resin material 210 matrix. The result of this circumstance would be a surface roughness uniformity with low-quality on the product.

Figure 4B: in this cross-section of the resin material 210, it can be seen that in a process step following the state of Figure 4A, a layer of copper has been deposited onto the main surface in an electro-less manner. Due to the uneven surface roughness and the holes 230, the copper layer is uneven as well and penetrates into the holes 230, resulting in not only low-quality electric connections but also low-quality of the product with defects such as copper remaining. Removal of such undesired copper structures is difficult afterwards in the following process and it will have high risks of product reliability.

<u>Summary of the Invention</u>

There may be a need to manufacture a component carrier, using a desmear process, in an efficient and robust manner.

A component carrier, a manufacture method and a use are provided.

According to an aspect of the invention, there is described a component carrier (e.g. a printed circuit board or an IC substrate), comprising: a (layer) stack comprising at least one electrically conductive layer structure and at least one electrically insulating layer structure.

The at least one electrically insulating layer structure comprises:

i) an insulating material (e.g. a resin), and
ii) fillers (in particular spherical fillers rather than fibrous filles) (filler particles) embedded in the insulating material.

At least one of said fillers is exposed (exposed filler) at one of the main surfaces (perpendicular along the stacking direction z, i.e. along x-y) (exposed surface portion) of the electrically insulating layer structure and said at least one exposed filler comprises a high-roughened surface portion and a low-roughened surface portion (wherein a surface roughness of the high-roughened surface portion is larger than a surface roughness of the low-roughened surface portion).

According to a further aspect of the invention, there is described a method of manufacturing a component carrier (e.g. as described above), the method comprising:

i) providing a stack comprising at least one electrically conductive layer structure and at least one electrically insulating layer structure, wherein the at least one electrically insulating layer structure has an exterior main surface defined at least partially by an insulating material and fillers which are embedded in the insulating material, and

ii) treating the exterior main surface (of the stack) by laser ablation (in particular an excimer laser) from a laser source, to thereby roughen an exposed surface portion of at least one filler (the exposed surface portion can be the result of the laser ablation or can be provided before the laser ablation (the filler was exposed before the laser ablation)).

According to a further aspect of the invention, there is described a use (method of using) of an excimer laser to perform a desmear process with respect to an exterior surface (portion) of an electrically insulating layer structure, having fillers embedded in an insulating material, of a component carrier stack.

In the context of the present document, the term "filler" may in particular refer to a material suitable to be embedded in electrically insulating material (e.g. resin). The filler may hereby be configured to provide a specific functionality in the insulating material, for example mechanical stabilization for the products, and the filler can also impact the dielectric property of the insulating material such as Dk, Df regarding the electrical performance. In an example, a filler may be configured as a particle such as a bead. While in an example the filler may be rather spherical, in another example, the filler may be formed as a fiber. In a preferred embodiment, spherical fillers are applied in the insulating (resin) material. A specific example of the electrically insulating layer structure may be an Ajinomoto Build-up Film (ABF), where spherical particles are embedded in a resin layer. In a further example, the filler material may be (essentially) not affected by a wet desmear process, in particular etching. In a specific example, the filler material comprises silicon dioxide. Additionally or alternatively, the filler material may comprise ceramic material, for example aluminum oxide and/or titanium oxide and/or boron nitride and/or silicon carbide. The filler can be solid or hollow.

In the context of the present document, the term "laser treatment" may in particular refer to a process of applying a laser beam to a component carrier, in particular a component carrier under manufacture. The laser treatment may be a laser ablation that removes material from an exposed surface portion. In the present context, such a laser treatment may be used to perform a desmear process, i.e. removing residues and/or roughen a surface. "Excimer (excited dimer) laser" may be specific a form of ultraviolet laser and may be an established technical term. The ultraviolet wavelength is usually from 100 nm to 400 nm and the extreme ultraviolet wavelength is from 10 nm to 100 nm.

In the context of the present document, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, a metal core substrate, an inorganic substrate and an IC (integrated circuit) substrate. A component carrier may also be a hybrid board combining different ones of the above mentioned types of component carriers. It may comprise at least one electrically insulating structure and electrically conductive structure.

The term "component carrier preform" (under manufacture) may refer to a semi-finished product that will result, after several process steps, in a final component carrier. A preform may e.g. be a panel that comprises a plurality of (semi-finished) component carriers that will be separated in a further manufacturing step.

In the context of the present document, the term "desmear process" may particularly denote a process in a component carrier manufacture that applies a desmear operation, i.e. a surface cleaning and/or roughening of a component carrier preform. In particular, resin surfaces and bore holes may be cleaned and surfaces may be roughened to improve adhesion properties. The desmear process may comprise wet desmear and dry desmear. The wet desmear may use liquid chemistry treating the surface and the dry desmear might use gas or laser attacking or treating the surface.

In the context of the present document, the term "surface roughness" may in particular refer to a property of a surface. The surface roughness may be seen as a relative term, for example the roughness of a first portion is high in comparison to the surface roughness of a second portion with a lower roughness.

The "roughness" of a surface quantifies the extent to which the surface deviates from its ideal form. Any deviations are usually analyzed in direction of the normal vector of the surface and are characterized by an amplitude, i.e.

the height or length of the deviations in surface normal direction, and by a frequency, denoting the amount or number of deviations per surface area. Surface roughness correlates with friction between interacting rough surfaces, if they are moved relative to each other.

One of the most common roughness parameters is Ra, which may be the arithmetic average of the absolute values of surface deviations from a mean surface profile. The unit of the roughness parameter Ra is length and it is typically measured in micrometers or nanometers. The mean surface profile may be filtered from the raw surface profile, i.e. the measured surface profile, e.g. by eliminating a waviness component of surface deviations.

Roughness Ra may thus be calculated as

$$Ra = \sum_{m=1,\ldots,M} \sum_{n=1,\ldots,N} |z(x_m, y_n) - <z>| / MN$$

with

$$<z> = \sum_{m=1,\ldots,M} \sum_{n=1,\ldots,N} z(x_m, y_n) / MN.$$

Here, the sampling points $(x_m, y_n)$ are equally spaced in directions x and y, which span the plane of the examined surface, and z is the direction normal to the examined surface. Thus, $z(x_m, y_n)$ denotes the surface deviation from the mean surface profile in direction of the surface normal at sampling point $(x_m, y_n)$. M and N determine the evaluation length in x-direction and in y-direction, respectively.

According to an exemplary embodiment, the present invention may be based on the idea that a component carrier can be manufactured, using a desmear process, in an efficient and robust manner, when the exposed surface portion of an electrically insulating layer structure (that comprises an insulating material with embedded fillers) is treated such that the fillers located near the exposed surface portion are treated as well and comprise, after the treatment step, a high-roughness surface portion and a low-roughness portion, respectively. In other words, the desmear process is conducted such that not only insulating material is removed and roughened, but also the embedded fillers. Thereby, some of the fillers will become exposed at the exposed surface portion of the insulating material and are roughened as well.

As a consequence, the roughness of the exposed surface portion may be especially uniform. In a further step of adding an electrically conductive layer (e.g. an electro-less copper layer, see Figure 4B above), said layer may be provided in an even manner without Eless penetration issues. By these measures, the overall product quality and reliability of the component carrier may be increased.

While conventional desmear processes (see above) apply a wet etching that affects the insulating material (significantly) more than the filler particles, thereby leading to the above discussed drawbacks, it has been found by the inventors that a more efficient and reliable process can be provided by treating insulating material and filler in a comparable manner. When the resin etched too much in the wet desmear process, the filler particles might not be bonded with the resin tightly as desired, and then filler particles might be detached from the component carrier and dropped, e.g. in the chemical process tank, which will contaminate the chemistry/products and will cause the waste of materials and lower the quality of the products. Additionally, the desmear process is not be able to form a uniform roughness of the insulating layer surface, therefore it might be difficult for fine line structuring and also cause some quality issues of products.

In a preferred embodiment, the treatment process may be done by laser treatment/ablation, e.g. using an excimer laser. It has been surprisingly found that this approach may be especially efficient in roughening insulating material and embedded fillers in a comparable manner. The described process may be implemented in existing production lines in a straightforward manner. Furthermore, costs of chemicals for wet etching can be avoided in this manner.

Exemplary Embodiments

According to an embodiment, the high-roughened surface portion is associated with the exposed portion of said at least one exposed filler. This structural feature may directly reflect the manufacture step of roughening the exposed surface portion of the insulating material and a portion of an embedded filler at the same time. In other words, a surface treatment step (e.g. using a laser) is performed on the electrically insulating layer structure main surface, thereby removing/roughing insulating material and also removing/roughening filler material. During this process, fully embedded fillers can become partially exposed at the exposed surface portion. This may have the advantage that the exposed surface portion is provided with a high degree of conformity. In the context of the present document, the term "main surface" of a body may particularly denote one of two largest opposing surfaces of the body or outermost or exposed opposing surfaces of the body. The main surfaces may be connected by circumferential side walls. The thickness of a body, such as the carrier body, may be defined by the distance between the two opposing main surfaces.

According to a further embodiment, a surface (exposed surface portion), where the at least one exposed filler is exposed, has a roughness value corresponding to the high-roughened surface portion of the at least one exposed filler and/or a different roughness value from the roughness of another surface portion on a main surface (in particular on the same main surface) of the electrically insulating layer structure). This may provide the advantage that a specific conformity and/or surface roughness may be achieved. Depending on the filler material, roughening (e.g. defined by Ra) of the exposed filler surface portion may be comparable/similar to the roughening of the insulating material exposed surface or different. Therefore, the roughness uniformity of the whole exposed surface maybe of high quality.

According to a further embodiment, the high-roughened surface portion of the filler protrudes beyond the insulating material. In this case, the filler material may be specifically stable against the treatment (desmear) process, i.e. being a highly stabilising material. Protrusions may be used as anchors to achieve a better connection to another layer structure, e.g. a copper layer. With some surface treatment, the wettability of the surface of fillers may become better, therefore the fillers might be preferably immerged or penetrated into one or more other insulating layer(s).

According to a further embodiment, the high-roughened surface portion of the filler is flush with the roughened surface of the insulating material. This may provide the advantage that the exposed surface portion comprises a high conformity.

According to a further embodiment, the low-roughened surface portion of the exposed filler faces away from the insulating material surface, where the exposed filler is exposed. This structural feature also reflects a manufacture step of roughening the insulating material surface portion and the filler exposed surface portion in the same treatment process. While the fillers generally comprise a low-roughness surface, said surface can be roughened during the treatment process. Hereby, only the surface portion becomes roughened that is associated with the exposed surface portion of the insulating material.

According to a further embodiment, the component carrier further comprises: at least one further electrically insulating layer structure, comprising a further insulating material and further fillers, wherein at least some of the further fillers respectively comprise a further high-roughened surface portion and a further low-roughened surface portion. This may provide the advantage that the stack comprises two or more layers that have been conducted to the advantageous desmear process. Accordingly, the overall product quality may be improved since there may be high quality uniformity of the insulating material surface and it may avoid the electro-less penetration and electro-less remains.

According to a further embodiment, the further low-roughened surface portion of the further exposed filler faces away from the further insulating material surface, where the further exposed filler is exposed (see above).

According to a further embodiment, the high-roughened surface portion of the exposed filler of the electrically insulating layer structure faces the further low-roughened surface portion of the further fillers of the further electrically insulating layer structure or the high-roughened surface portion of the exposed filler of the electrically insulating layer structure faces the further low-roughened surface portion of the further fillers of the further electrically insulating layer structure. Advantageously, the insulating layer and the further insulating layer may be (directly) stacked one above the other in the stack. Depending on the positioning, low-roughness surface portions of the one layer may face high-roughness surface portion of the other layer in the vertical (z) direction.

According to a further embodiment, the high-roughened surface portion of the exposed filler and/or further high-roughened surface of the further filler has a roughness Ra of more than 100 nm, in particular more than 200 nm, more in particular more than 500 nm. Accordingly, the roughness may be suitable for connecting a metal layer efficiently and robustly, thereby avoiding delamination (and copper remaining for the electro-less penetration). In an embodiment, the roughness is in the range 50 nm to 300 nm. In a further embodiment, the roughness is 200 nm or higher. If roughness is too high, it may have an impact on signal transmission efficiency. If roughness is too low, it may cause high yield loss.

According to a further embodiment, the low-roughened surface portion of the exposed filler has a roughness Ra below 100 nm. It may follow that the filler surface portion, without additional roughening, would not be suitable for connecting a metal layer efficiently and robustly.

According to a further embodiment, the fillers have a diameter in a range from 50 nm to 30 $\mu$m, in particular 50 nm to 15 $\mu$m. This range may be especially efficient for stabilizing the insulating material, yet allowing a certain flexibility/-bendability. In an example, depending on the molding (matrix) material, the maximum filler size may be around 10 $\mu$m or higher. Considering nanofiller ABF, the filler size range may be in the range 10 nm to 15 $\mu$m.

According to a further embodiment, the fillers comprise silicon dioxide or other (combined compound of) inorganic material (the inorganic filler may be used alone or in combination with two or more kinds at an arbitrary ratio, with which the thermal expansion coefficient of the cured material obtained by curing the resin composition can be reduce and warpage can be controlled). The filler particles can get the depth of the recessed portion of the polishing surface of resin smaller and get the dielectric loss tangent of a cured material obtained by curing the resin composition reduced. Additionally, the fillers may help to reduce the tensile elastic modulus of the cured material. Moreover, the filler particles may be preferably surface-treated with a suitable surface treatment as the surface treatment can suppress the aggregation of the particles of the filler or the detachment of the particles of the filler from the polished surface and it may get a better uniformity on the resin sheet surface and improve the moisture resistance and dispersibility of the particle fillers. Said material may efficiently stabilize the insulating material but leads to drawbacks in the desmear etching process (see above) and the filler with different material inside or different shape or even different size will impact the dielectric property of the insulating material regarding the electrical performance. However, by treating the exposed surface portions of the silicon dioxide fillers and the insulating material together (in particular by laser ablation), the advantages of high stabilisation and surface roughness conformity can be combined.

In a further embodiment, the filler may comprise a conductive particle, e.g. an electrically insulating material (i.e. polymer material) coated with electrically conductive metal such as gold, nickel, etc.

According to a further embodiment the laser source comprises an excimer laser. This may provide the advantage that a highly precise and established technology can be directly applied for the desmear process with a high efficiency from a manufacturing point of view.

According to a further embodiment, the method further comprises: arranging a mask, in particular a glass mask, between the stack and the laser source. The laser pattern on the surface may directly depend on the design of the glass mask. Thereby, specific tasks may be selectively fulfilled, e.g. focussing on vias or pattern regions (see examples in Figures 3A to 3D). Thereby, the manufacture method may be rendered more design flexible for different products and fulfil different function of products.

According to a further embodiment, the mask is partially transmissive and partially opaque for laser light from the laser source (so that only the surface of the insulating layer structure overlapped by the transmissive portion of the mask is treated by the laser ablation). In this manner, a design flexible laser pattern can be achieved in an easy and straightforward manner.

According to a further embodiment, the method further comprising: rinsing the stack before and/or after the laser treatment. Such a cleaning step may further improve the product quality. In particular, a conform surface roughness may enable a more efficient cleaning process.

According to a further embodiment, the method further comprising: metallizing the roughened main surface of the at least one electrically insulating layer structure, in particular of the insulating material. Due to the surface roughness, an electrically conductive layer (metal layer) may be provided onto the electrically insulating layer structure in an efficient and robust manner. In the first place, a seed layer may be provided in an electro-less manner (e.g. sputtering). In a further step, an electrically conductive layer may be provided, e.g. by plating.

According to a further embodiment, the method further comprising: subjecting the stack to lamination and/or laser drilling before performing said laser treatment. This may provide the advantage of an especially efficient process: vias may be formed by laser drilling and afterwards, a desmear process is performed using said laser.

According to a further embodiment, the method further comprising: repeating said laser treatment with a further electrically insulating layer structure of the stack, wherein the further electrically insulating layer structure comprises a further insulating material and further fillers embedded in said further insulating material. In this manner, the described method may be directly implemented into existing component carrier manufactures, in particular build-up processes.

According to a further embodiment, the at least one of the following advantages may be achieved: excimer laser ablates both resin and ($SiO_2$) filler, ablation depth can be controlled by excimer recipe, uniformity (ABF) surface roughness, no uneven e-less copper penetration issue, dry process, reduce cost of chemicals (etching).

According to a further embodiment, a selective roughening is performed (e.g. using a mask, see Figure 3D) for at least two different portions on the same surface of insulating material. That means there will be at least one smooth portion and at least one rough portion on one and the same surface. With this design, the fine structuring and high density of a component carrier product may be achieved. Further, the design-flexibility with respect to specific functionalities may be highly improved.

According to a further embodiment, at least 30% (in particular at least 40%, more in particular at least 50%, more in particular at least 60%) of the volume of the insulating material of the at least one electrically insulating layer is occupied by fillers (filler particles). Thereby, a stable and robust, yet flexible insulating layer may be provided.

According to a further embodiment, at least 3% (in particular at least 5%, more in particular at least 10%) of the total amount of said fillers comprises the high-roughened surface portion. Thus, a high amount of fillers are exposed (due to a high number of fillers) but (essentially) without causing an adhesion issue.

According to a further embodiment, at least some of the fillers are in direct (physical) contact to each other. This may be due to a high number (and/or large size) of fillers, enabling a stable insulating layer.

According to a further embodiment, the high-roughened surface of at least some fillers (in particular of (essentially) all fillers, is free of contact (not in contact) to another (one of the) filler(s). In other words, the roughened surface is only present at the main surface, where no contact to other fillers is provided. Thereby, the treatment method may function especially efficient.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

EP 4 492 927 A1

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise for example resin and/or glass fibers, so-called prepreg or FR4 material, PID, or ABF. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). In another embodiment, the substrate may be substantially larger than the assigned component (for instance in a flip chip ball grid array, FCBGA, configuration). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, magnesium, carbon, (in particular doped) silicon, titanium, and platinum. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one further component may be embedded in and/or surface mounted on the stack. The component and/or the at least one further component can be selected from a group consisting of an electrically nonconductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide $(Al_2O_3)$ or aluminum nitride (AlN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide ($Ga_2O_3$), indium gallium arsenide (InGaAs), indium phosphide (InP) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), Electroless Nickel Electroless Palladium Immersion Gold (ENEPIG), gold (in particular hard gold), chemical tin (chemical and electroplated), nickel-gold, nickel-palladium, etc. Also nickel-free materials for a surface finish may be used, in particular for high-speed applications. Examples are ISIG (Immersion Silver Immersion Gold), and EPAG (Electroless Palladium Autocatalytic Gold).

Brief Description of the Drawings

The aspects defined above and further aspects of the invention are apparent from the examples of embodiment to be described hereinafter and are explained with reference to these examples of embodiment.

Figure 1 shows a component carrier according to an exemplary embodiment of the invention.
Figure 2 shows a laser treatment apparatus according to an exemplary embodiment of the invention.
Figures 3A to 3D respectively show a mask for a laser treatment apparatus according to exemplary embodiments of the invention.

Figures 4A and 4B respectively show a conventional circuit board.

Detailed Description of the Drawings

The illustrations in the drawings are schematic. In different drawings, similar or identical elements are provided with the same reference signs.

**Figure 1** shows a component carrier 100 according to an exemplary embodiment of the invention. The component carrier comprises a stack 101 with at least one electrically conductive layer structure 104 and (in this example) two electrically insulating layer structures stacked on top of each other. The lower electrically insulating layer structure 102 comprises an insulating material 110 such as a resin, for example ABF, and fillers 120 embedded in the insulating material 110. The fillers 120 are in this example filler beads (spherical, not fibers) embedded in the resin. In a specific example, the fillers 120 have a diameter in a range from 50 nm to 15 $\mu$m and/or comprise silicon dioxide. A plurality of the fillers 120 are exposed at the upper main surface 105 of the lower electrically insulating layer structure 102.

It can be seen that the exposed fillers 120 respectively comprise a high-roughened surface portion 125 and a low-roughened surface portion 126. The high-roughened surface portion 125 is hereby associated with the exposed portion of the respective filler 120, while the low-roughed surface portion 126 is associated with the not-exposed, embedded portion of the respective filler 120.

The upper main surface 105 of the electrically insulating layer structure 102, where the exposed fillers 120 are exposed, has a roughness value (e.g. Ra > 100 nm) corresponding to the high-roughened surface portion 125 of the exposed fillers 120. In another embodiment, the roughness values can also be different. Further, the high-roughened surface portion 125 of the fillers 120 is flush with the roughened insulating material surface 105. In another embodiment, high-roughened surface portion 125 of the fillers 120 can also protrude from the roughened insulating material surface 105. The low-roughened surface portion 126 of the exposed fillers 120 in turn faces away from the insulating material surface 105, where the exposed fillers 120 are exposed.

The stack 101 further comprises a further electrically insulating layer structure 112, here on top of the lower electrically insulating layer structure 102, comprising a further insulating material 111 and further fillers 121 (in this example also filler beads), wherein a plurality of the further fillers 121 respectively comprises a further high-roughened surface portion and a further low-roughened surface portion. The further low-roughened surface portion of the further exposed fillers 121 faces away from the further insulating material 111 surface, where the further exposed fillers 121 are exposed. In this example, the further low-roughened surface portion of the further exposed fillers 121 of the further electrically insulating layer structure 112 face the high-roughened surface portion 125 of the exposed fillers 120 of the electrically insulating layer structure 102. A metal (copper) layer 104 has been arranged on the further insulating material 111 surface. Due to the surface roughness, the connection between insulating material and metal is stable and robust with good uniformity.

**Figure 2** shows a laser treatment apparatus 160 according to an exemplary embodiment of the invention. In this exemplary embodiment, the laser treatment apparatus 160 comprises a laser source 140 (here an excimer laser) to provide the laser light/beam. The beam is attenuated by an attenuator 141 and send via a telescope 142, a homogenizer 143, and a field lens 144 to mask 150 (the beam path is directed using mirrors M1 to M3). After passing through the mask 150, the beam is projected, using projecting lens 145, onto a substrate, here a component carrier layer stack 101 (a component carrier under manufacture). Thereby, the laser light/beam may be applied to a local surface area of the component carrier layer stack 101 (as seen in Figure 2) or may be applied to a total surface area of the component carrier layer stack 101 (not shown).

**Figures 3A to 3D** respectively show an example of a mask 150 (e.g. a glass mask) for a laser treatment apparatus (e.g. as described above) according to exemplary embodiments of the invention. The laser beam can pass through the white areas but not through the black areas. Then, it will generate the pattern on the surface of the component carrier corresponding to the design of mask.

Figure 3A: this mask 150 is suitable for an entire surface roughening. The material roughness can e.g. depend on black region size and density, and excimer parameters.

Figure 3B: this mask 150 is suitable for via bottom residue removal and/or via design. The white circles are used to apply the excimer laser to the via locations.

Figure 3C: this mask 150 is suitable for both, surface roughening and via bottom residue removal and/or via design. The white circles are used to apply the laser to the via locations; the laser can roughen the surface and simultaneously remove residue at the via bottom.

Figure 3D: this mask 150 is suitable for selective roughing and/or pattern design. The white region can be used to apply the laser to the pattern region. The selective roughening for different portions can be provided on the same surface of insulating material. That means there will be a smooth portion and a rough portion on one and the same surface. With this design, the fine structuring and high density of a component carrier product may be achieved.

Reference signs

| 100 | Component carrier |
| 101 | Stack |
| 102 | Electrically insulating layer structure |
| 104 | Electrically conductive layer structure |
| 105 | Exterior/exposed main roughened surface (of the insulating material) |
| 110 | Insulating material |
| 111 | Further insulating material |
| 112 | Further electrically insulating layer structure |
| 120 | Fillers |
| 121 | Further fillers |
| 125 | High-roughened surface portion |
| 126 | Low-roughened surface portion |
| 140 | Laser source |
| 141 | Attenuator |
| 142 | Telescope |
| 143 | Homogenizer |
| 144 | Field lens |
| 145 | Projection lens |
| 150 | Mask |
| 160 | Laser treatment |
| M | Mirror |

| 200 | Conventional circuit board |
| 210 | Conventional insulating material |
| 220 | Conventional filler particles |
| 230 | Hole |
| 240 | Electroless copper layer |

**Claims**

1. A component carrier (100), comprising a stack (101) having at least one electrically conductive layer structure (104) and at least one electrically insulating layer structure (102), wherein the at least one electrically insulating layer structure (102) comprises:

   an insulating material (110), and
   fillers (120) embedded in the insulating material (110), wherein at least one of said fillers (120) is exposed at one of the main surfaces (105) of the at least one electrically insulating layer structure (102);
   wherein said at least one exposed filler (120) comprises a high-roughened surface portion (125) and a low-roughened surface portion (126).

2. The component carrier (100) according to claim 1,

   wherein the high-roughened surface portion (125) is associated with the exposed portion of said at least one exposed filler (120) and/or
   wherein the low-roughened surface portion (126) is associated with the not-exposed portion of said at least one exposed filler (120).

3. The component carrier (100) according to claim 1 or 2, wherein a surface portion, where the at least one exposed filler (120) is exposed, has a roughness value corresponding to the high-roughened surface portion (125) of the at least one exposed filler (120) and/or a different roughness value from the roughness value of another surface portion on a main surface, in particular on the same main surface, of the at least one electrically insulating layer structure (102).

4. The component carrier (100) according to any one of the preceding claims,

wherein the high-roughened surface portion (125) of the filler (120) protrudes beyond the insulating material (110); and/or

wherein the low-roughened surface portion (126) of the exposed filler (120) faces away from the main surface (105) of the insulating material (110), where the exposed filler (120) is exposed.

5. The component carrier (100) according to any one of the preceding claims, further comprising:

at least one further electrically insulating layer structure (112), comprising a further insulating material (111) and further fillers (121), wherein at least some of the further fillers (121) respectively comprise a further high-roughened surface portion and a further low-roughened surface portion; wherein in particular

the further low-roughened surface portion of the further exposed filler (121) faces away from the further insulating material (111) surface, where the further exposed filler (121) is exposed,

wherein further in particular

the high-roughened surface portion (125) of the exposed filler (120) of the electrically insulating layer structure (102) faces the further low-roughened surface portion of the further fillers (121) of the further electrically insulating layer structure (112).

6. The component carrier (100) according to any one of the preceding claims,

wherein the high-roughened surface portion (125) of the exposed filler (120) has a roughness Ra of more than 100 nm; and/or

wherein the low-roughened surface portion (126) of the exposed filler (120) has a roughness Ra below 100 nm.

7. The component carrier (100) according to any one of the preceding claims,

wherein the fillers (120) have a diameter in a range from 50 nm to 30 $\mu$m; and/or

wherein the fillers (120) comprise silicon dioxide.

8. The component carrier (100) according to any one of the preceding claims, wherein at least 40% of the volume of the insulating material (110) of the at least one electrically insulating layer structure (102) is occupied by fillers (120), in particular wherein at least 5% of the total amount of said fillers (120) comprises the high-roughened surface portion (125).

9. The component carrier (100) according to any one of the preceding claims, wherein at least some of the fillers (120) are in direct contact to each other, in particular wherein the high-roughened surface (125) of at least some fillers, in particular of essentially all fillers (120), is free of contact to another filler.

10. A method of manufacturing a component carrier (100), the method comprising:

providing a stack (101) comprising at least one electrically conductive layer structure (104) and at least one electrically insulating layer structure (102), wherein the at least one electrically insulating layer structure (102) has an exterior main surface (105) defined at least partially by an insulating material (110) and fillers (120) which are embedded in the insulating material (110); and

treating the exterior main surface (105) by laser ablation from a laser source (140), to thereby roughen an exposed surface portion (125) of at least one filler (120).

11. The method according to claim 10, wherein the laser source (140) comprises an excimer laser.

12. The method according to claim 10 or 11, wherein the method further comprises: arranging a mask (150), in particular a glass mask, between the stack (101) and the laser source (140);

wherein in particular

the mask (150) is partially transmissive and partially opaque for laser light from the laser source (140), so that only the surface of the insulating layer structure (102) overlapped by the transmissive portion of the mask (150) is treated by the laser ablation.

13. The method according to any one of claims 10 to 12, the method further comprising:

rinsing the stack (101) before and/or after the laser treatment; and/or
metallizing (104) a roughened main surface (105) of the at least one electrically insulating layer structure (102), in particular of the insulating material (110); and/or
subjecting the stack (101) to lamination and/or laser drilling before performing said laser treatment.

14. The method according to any one of claims 10 to 13, the method further comprising:
repeating said laser treatment with a further electrically insulating layer structure (112) of the stack (101), wherein the further electrically insulating layer structure (112) comprises a further insulating material (111) and further fillers (121) embedded in said further insulating material (111).

15. Using an excimer laser (140) to perform a desmear process with respect to an exterior main surface (105) of an electrically insulating layer structure (102), having fillers (120) embedded in an insulating material (110), of a component carrier stack (101).

Fig. 1

Fig. 2

Fig. 3A    Fig. 3B    Fig. 3C    Fig. 3D

Fig. 4A -prior art-    Fig. 4B -prior art-

Europäisches
Patentamt

European
Patent Office

Office européen
des brevets

# EUROPEAN SEARCH REPORT

**Application Number**

EP 24 16 5021

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/240358 A1 (NAKAI TORU [JP] ET AL) 6 October 2011 (2011-10-06) | 1-15 | INV. H05K3/00 |
| Y | * paragraphs [0065], [0073] - [0076], [0101], [0120], [0124]; figures 6-9,12,19-22 * | 10-15 | ADD. H05K1/03 H05K3/38 |
| X | US 2023/180385 A1 (FUKUI SHOGO [JP] ET AL) 8 June 2023 (2023-06-08) | 1-9 | H05K3/10 |
| Y | * paragraphs [0031], [0056], [0064], [0072] - [0078], [0081]; figures 7A-7G * | 10-15 | |
| X | JP H11 6073 A (OMRON TATEISI ELECTRONICS CO) 12 January 1999 (1999-01-12) | 15 | |
| Y | * paragraphs [0012], [0016], [0064], [0068] * | 10-13,15 | |

| | TECHNICAL FIELDS SEARCHED (IPC) |
|---|---|
| | H05K |

The present search report has been drawn up for all claims

| Place of search | Date of completion of the search | Examiner |
|---|---|---|
| The Hague | 24 September 2024 | Zimmer, René |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

 

& : member of the same patent family, corresponding
document

EPO FORM 1503 03.82 (P04C01)

2

## ANNEX TO THE EUROPEAN SEARCH REPORT
## ON EUROPEAN PATENT APPLICATION NO.

EP 24 16 5021

This annex lists the patent family members relating to the patent documents cited in the above-mentioned European search report.
The members are as contained in the European Patent Office EDP file on
The European Patent Office is in no way liable for these particulars which are merely given for the purpose of information.

24-09-2024

| Patent document cited in search report | Publication date | Patent family member(s) | Publication date |
|---|---|---|---|
| US 2011240358 A1 | 06-10-2011 | CN 102918935 A | 06-02-2013 |
| | | JP 5391329 B2 | 15-01-2014 |
| | | JP WO2011122244 A1 | 08-07-2013 |
| | | KR 20130018819 A | 25-02-2013 |
| | | TW 201212739 A | 16-03-2012 |
| | | US 2011240358 A1 | 06-10-2011 |
| | | WO 2011122244 A1 | 06-10-2011 |
| US 2023180385 A1 | 08-06-2023 | CN 116230679 A | 06-06-2023 |
| | | JP 2023084016 A | 16-06-2023 |
| | | TW 202335552 A | 01-09-2023 |
| | | US 2023180385 A1 | 08-06-2023 |
| JP H116073 A | 12-01-1999 | NONE | |

EPO FORM P0459

For more details about this annex : see Official Journal of the European Patent Office, No. 12/82